# DEMANDE DE BREVET EUROPEEN

(11) **EP 0 566 206 A1**
(43) Date de publication de la demande: **20.10.1993**
(21) Numéro de dépôt: 93201083.8
(22) Date de dépôt: 14.04.1993
(51) Int. Cl.: H01R 4/32, H01R 9/05, H01R 9/09

(54) **Dispositif de connexion**

(30) Priorité: 15.04.1992 FR 9204615
(71) Demandeur: PHILIPS ELECTRONIQUE GRAND PUBLIC, 92150 Suresnes (FR); Philips Electronics N.V., 5621 BA Eindhoven (NL)
(72) Inventeur: Chanteau, Pierre, Société Civile S.P.I.D., F-75008 Paris (FR)
(74) Mandataire: Caron, Jean

(57) **Abrégé**

Dispositif pour la connexion électrique d'un câble muni d'une âme électriquement conductrice sur un circuit imprimé fixé dans un boîtier, au moyen d'un corps tubulaire divisé longitudinalement en plusieurs branches entre lesquelles passe l'âme conductrice du câble, et présentant un filetage prévu pour y visser un chapeau fileté muni d'un noyau qui appuie sur l'âme conductrice du câble. Selon l'invention, le circuit imprimé est muni d'orifices pour laisser passer les branches du corps tubulaire, ces orifices laissent entre eux un pont qui passe entre les branches du corps tubulaire, pont sur lequel est présente au moins une piste conductrice et sur lequel le dit noyau appuie l'âme du câble.
Applications : Boîtiers coupleurs, amplificateurs , répartiteurs, dans un système de distribution de télévision (CATV ou MATV).

## Description

La présente invention concerne un dispositif pour la fixation d'un câble muni d'une âme électriquement conductrice et la connexion électrique de la dite âme à un autre conducteur, au moyen d'un corps tubulaire fixé dans un boîtier, le dit corps tubulaire étant divisé longitudinalement en plusieurs branches entre lesquelles passe l'âme conductrice du câble, et présentant un filetage prévu pour y visser un chapeau fileté muni d'un noyau qui appuie sur l'âme conductrice du câble

Un tel dispositif est connu du brevet français n° 1.264.411. Dans l'art antérieur il est utilisé dans le domaine de la construction électrique par exemple dans les boîtiers d'interconnexions des installations électriques domestiques.

L'invention a pour but de fournir un dispositif qui permette, dans l'industrie des appareils électroniques notamment pour la réception et la distribution de la télévision, de connecter et de fixer un câble à un circuit imprimé sans devoir ajouter une étape de réalisation dans le cycle de fabrication du dit circuit imprimé, telle que la fixation de pièces par vissage sur le circuit ou par soudage à la main après passage du circuit à la vague de soudage.

A cet effet, dans le dispositif selon l'invention, le dit autre conducteur est une piste conductrice d'un circuit imprimé constitué de pistes conductrices sur un substrat isolant, ce substrat est muni de plusieurs orifices pour laisser passer les branches du corps tubulaire, les orifices laissent entre eux un pont qui passe entre les branches du corps tubulaire, pont sur lequel est présente au moins une piste conductrice et sur laquelle appuie le dit noyau.

L'invention est ainsi basée sur l'idée de munir le circuit imprimé d'orifices entre lesquels passe un conducteur, afin de permettre la saisie de ce conducteur dans une borne de connexion de l'art antérieur.

Avec ce moyen, non seulement le câble est fixé de façon économique au circuit imprimé, mais en outre le circuit imprimé lui même est fixé au boîtier par la même occasion.

Le corps tubulaire est avantageusement fait d'une matière isolante, et le boîtier est métallique ou métallisé.

Ainsi le boîtier assure un blindage électromagnétique et néanmoins le corps de la borne de connexion ne provoque pas le court-circuit du conducteur vers la masse.

Dans une forme particulière de réalisation, un moyen de maintien du circuit imprimé est attaché au corps tubulaire.

Ainsi, le circuit imprimé peut être fixé au boîtier sans que l'on ait à prévoir d'autres dispositions à cet effet.

Dans une variante de réalisation, le boîtier comporte une paroi située dans le prolongement du dit pont et cette paroi est percée d'un canal pour le passage du câble électrique de liaison et d'un trou fileté qui recoupe ledit canal et dans lequel est vissée une vis pour serrer le câble, le boîtier étant métallique ou métallisé après la formation du canal.

Le dit corps étant obtenu par moulage, le dispositif comporte avantageusement une pluralité des dits corps qui sont présentés sous la forme d'une pluralité de corps reliés entre eux par un élément moulé en même temps que les corps, les corps étant ainsi tenus l'un par rapport à l'autre dans des positions correspondant à leurs positions sur le circuit imprimé.

Ainsi le montage de la pluralité de bornes est facilité, sans que le prix des bornes proprement dites ne soit pratiquement augmenté.

Ces aspects de l'invention ainsi que d'autres aspects plus détaillés apparaîtront plus clairement grâce à la description suivante de modes de réalisation non limitatifs.

La figure 1 est une vue en perspective et partiellement éclatée d'un dispositif selon l'invention, vue sur laquelle manque le boîtier, pour une meilleure visibilité des éléments situés à l'intérieur.

La figure 2 est une vue en coupe d'une partie d'un dispositif selon l'invention.

La figure 3 est une vue en perspective d'une forme particulière de réalisation d'une pluralité de corps tubulaires.

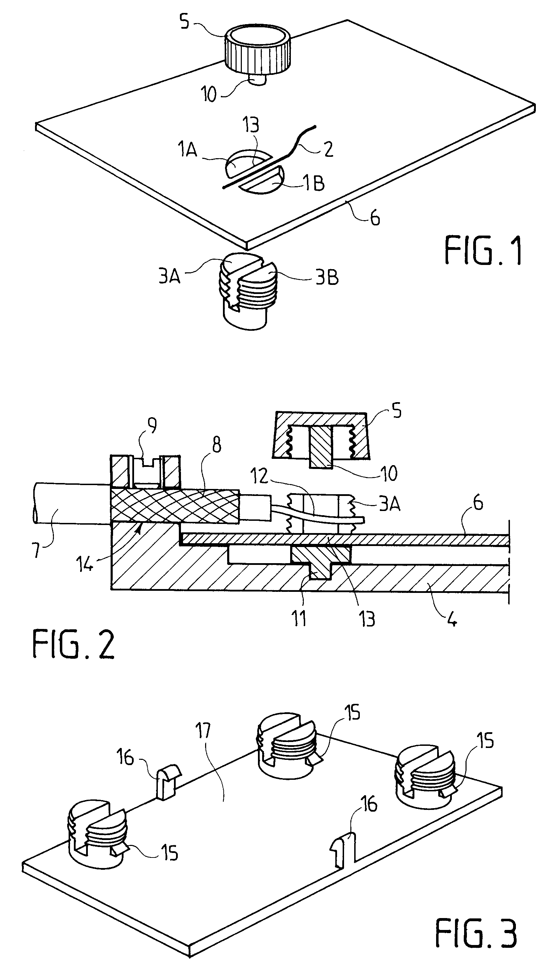

L'appareil représenté sur les figures 1 et 2 est par exemple ce qu'on appelle dans le vocabulaire du métier un boîtier de répartition ou encore un séparateur, un amplificateur ou un coupleur, autrement dit un des divers appareils susceptibles d'être utilisés dans un système de distribution de télévision. Il comporte essentiellement un boîtier qui a pour fonction à la fois la protection mécanique et le blindage contre le rayonnement électromagnétique, à l'intérieur duquel est enfermé un circuit imprimé, constitué de pistes conductrices sur un substrat isolant, qui porte le circuit électrique fonctionnel de l'appareil.

Cet appareil étant destiné à être utilisé dans un système de distribution de télévision, il doit pouvoir être raccordé à un ou plusieurs câbles de raccordement, servant à relier cet appareil à un autre appareil de technologie semblable, à une antenne ou encore à une prise d'appartement.

La figure 1 montre comment, pour relier l'âme conductrice d'un câble blindé à un circuit imprimé 6, on utilise un corps tubulaire divisé longitudinalement en deux branches 3A, 3B, et présentant à l'extérieur un filetage prévu pour y visser un chapeau 5 dont la paroi intérieure est filetée et qui est muni d'un noyau 10 qui, lorsque le chapeau est vissé, pénêtre entre les deux branches 3A et 3B.

Le circuit imprimé est muni d'orifices 1A et 1B entre lesquels existe un pont 13 sur lequel est présente au moins une piste conductrice imprimée 2. Les branches du corps tubulaire 3A et 3B de la borne de connexion passent respectivement dans les orifices 1A et 1B du circuit imprimé.

La figure 2 montre comment l'âme conductrice 12 du câble est introduite dans le corps tubulaire, entre les parties 3A et 3B, au dessus du pont 13, et le noyau 10 du bouchon, lorsque ce dernier est vissé, appuie l'âme 12 du câble sur le pont 13 qui passe entre les branches du corps tubulaire. Le corps tubulaire est fait d'une matière isolante, et le boîtier est métallique ou métallisé. Le corps tubulaire est fabriqué par exemple par moulage avec une matière plastique thermoformable. Le corps tubulaire est fixé dans le boîtier 4, par exemple au moyen d'un téton 11 dont est muni le corps à sa partie inférieure et qui est serti dans le fond du boîtier.

Pour fixer et relier électriquement à la masse du boîtier le blindage 8 du câble 7, la paroi du boîtier située dans le prolongement du pont, c'est-à-dire celle à gauche sur la figure 2, est percée d'un canal 14 pour le passage du câble, et d'un trou fileté qui recoupe ledit canal 14 et dans lequel est vissée une vis sans tête 9 pour serrer le câble. Dans le cas d'un boîtier métallisé, celui-ci est métallisé après la formation du canal 14, de façon que le canal 14 soit métallisé intérieurement. La gaine isolante du câble est ôtée sur une certaine longueur pour faire apparaître la tresse ou le feuillard de blindage 8, afin qu'il soit en contact avec la paroi du canal 14 et/ou avec la vis 9 métallique.

Il va de soi que le boitier 4 doit être muni d'un couvercle de fermeture, bien que ce dernier ne soit pas représenté, pour alléger la figure.

Un tel appareil comporte en général plusieurs points de connexion pour relier plusieurs câbles. La figure 3 montre comment, pour le montage des bornes correspondantes, les corps tubulaires de ces bornes sont présentés sous la forme d'une pluralité de corps reliés entre eux par un élément 17 moulé en même temps que les corps, et les corps sont ainsi tenus l'un par rapport à l'autre dans des positions correspondant aux orifices prévus dans le circuit imprimé.

Les corps tubulaires représentés à la figure 3 sont muni de reliefs 15 en forme de crochets qui permettent la tenue en place d'un circuit imprimé avant même que le ou les bouchons 5 soient vissés. L'élément 17 moulé en même temps que les corps peut aussi être lui même muni de tels moyens de maintien du circuit imprimé, par exemple des pattes à crochets 16.

Des variantes de réalisation sont possibles : par exemple le corps 3 de la borne peut être divisé en plus de deux branches, ou bien le filetage du corps peut être intérieur et c'est alors le noyau 10 qui est fileté à la place du bouchon 5.

## Revendications

1. Dispositif pour la fixation d'un câble muni d'une âme électriquement conductrice (12) et la connexion électrique de la dite âme à un autre conducteur, au moyen d'un corps tubulaire (3) fixé dans un boîtier, le dit corps tubulaire étant divisé longitudinalement en plusieurs branches (3A, 3B) entre lesquelles passe l'âme conductrice du câble, et présentant un filetage prévu pour y visser un chapeau (5) muni d'un noyau (10) qui appuie sur l'âme conductrice du câble, caractérisé en ce que le dit autre conducteur est une piste conductrice d'un circuit imprimé (6) constitué de pistes conductrices sur un substrat isolant, en ce que ce substrat est muni de plusieurs orifices (1A, 1B) pour laisser passer les branches (3A, 3B) du corps tubulaire, et en ce que ces orifices laissent entre eux un pont (13) qui passe entre les branches du corps tubulaire, pont sur lequel est présente au moins une piste (2) conductrice et sur laquelle appuie le dit noyau.

2. Dispositif selon la revendication 1, caractérisé en ce que le corps tubulaire (3) est fait d'une matière isolante, et le boîtier (4) est métallique ou métallisé.

3. Dispositif selon la revendication 1, caractérisé en ce qu'au corps tubulaire (3) est attaché un moyen de maintien du circuit imprimé.

4. Dispositif selon la revendication 1, dont le boîtier comporte une paroi située en face du dit pont, caractérisé en ce que cette paroi est percée d'un canal (14) pour le passage du câble électrique de liaison, et d'un trou fileté qui recoupe ledit canal et dans lequel est vissée une vis (9) pour serrer le câble, le boîtier étant métallique ou métallisé après la formation du canal (14).

5. Dispositif selon la revendication 1, pour lequel le dit corps est obtenu par moulage, caractérisé en ce qu'il comporte une pluralité des dits corps (3) qui sont présentés sous la forme d'une grappe de corps reliés entre eux par des éléments moulés (17) en même temps que les corps, les corps étant ainsi tenus l'un par rapport à l'autre dans des positions correspondant à leurs positions sur le circuit imprimé.
